# EUROPEAN PATENT APPLICATION

(11) **EP 0 851 487 A1**
(43) Date of publication of application: **01.07.1998**
(21) Application number: 97122561.0
(22) Date of filing: 19.12.1997
(51) Int. Cl.: H01L 21/8249

(54) **Antimony-phosphor buried layer for a MOs FET or like semiconductor device, and method of fabrication**

(30) Priority: 27.12.1996 JP 357540/96
(71) Applicant: SANKEN ELECTRIC CO., LTD., Niiza-shi Saitama-ken (JP)
(72) Inventor: Sugita, Kazuyoshi, Iwatsuki-shi, Saitama-ken (JP); Iwabuchi, Akio, Setagaya-ku, Tokyo (JP)
(74) Representative: Strych, Werner Maximilian Josef, Dr.

(57) **Abstract**

A composite semiconductor device is disclosed which is a one-piece construction of a metal oxide semiconductor field effect transistor and a bipolar transistor.

In order to lower the on-state resistance of the MOS FET without giving an adverse effect to the bipolar transistor, buried layers for the component transistors are formed first by introducing antimony into first and second selected parts (20*a* and 11*a*') of a *p* type semiconductor substrate (1). Phosphor, more diffusive than antimony, is then introduced approximately into the first selected part of the substrate. As an *n* type epitaxial layer (4) is subsequently grown on the substrate, there are formed for the MOS FET a buried layer (20) in which antimony is higher in concentration than phosphor, and a pair of additional buried layers (21*a* and 21*b*) in which phosphor is higher in concentration than antimony. A buried layer (11) for the bipolar transistor is completed simultaneously which includes the preformed second selected part (11*a*) of the substrate and part (11*b*) newly formed in the epitaxial layer and which contains antimony only.

## Description

### BACKGROUND OF THE INVENTION

This invention relates to semiconductor devices having a buried layer or layers, and to a method of fabricating such devices. A typical example of semiconductor devices to which the present invention pertains is a composite semiconductor device integrally comprising an insulated gate (IG) or metal oxide semiconductor (MOS) field effect transistor (FET) and a bipolar transistor (BPT), both including a buried layer.

The composite semiconductor device has been known which is a one piece construction of a MOS FET and a BPT. In the manufacture of this composite semiconductor device, difficulties have been experienced in achieving a sufficiently low drain-source on-state resistance for the MOS FET. An obvious solution to this problem might be to increase the impurity concentration, and hence decrease the resistance, of the *n* type drain region, which overlies an *n*⁺ type buried layer, of the MOS FET. This solution is unsatisfactory because the drain region of the MOS FET is grown epitaxially at the same time with the *n* type collector region, also overlying an *n*⁺ type buried layer, of the BPT. Inevitably, therefore, an increase in the impurity concentration of the MOS FET drain region would incur an increase in that of the BPT collector region, impairing the voltage withstanding capability of the BPT. Completely different approaches must be tried for reduction of the on-state resistance of the MOS FET.

### SUMMARY OF THE INVENTION

The present invention seeks to make materially lower than heretofore the on-state resistance of MOS FETs or like semiconductor devices having a buried layer, without any such accompanying drawbacks or inconveniences as have been encountered heretofore.

Stated in its perhaps broadest aspect, the invention provides, in a method of fabricating a semiconductor device such as a MOS FET in combination with a BPT, the steps of: (a) providing a *p* type semiconductor substrate; (b) introducing a first impurity of *n* conductivity type, typically antimony, into selected part of the substrate through a major surface thereof; (c) introducing a second impurity of *n* conductivity type that is higher in diffusivity than the first impurity, typically phosphor, into approximately the same selected part of the substrate through the major surface thereof, thereby forming, thanks to the difference in diffusivity between the first and the second impurities, part of what is to become a first buried layer in which the first impurity is higher in concentration than the second impurity, and a second buried layer in which the second impurity is higher in concentration than the first impurity; and (d) growing an *n* type semiconductor epitaxial layer on the major surface of the substrate, thereby forming, thanks to thermal diffusion of the first and the second impurities from the substrate into the epitaxial layer at different rates, the first buried layer which comprises the part preformed in the substrate and part newly formed in the epitaxial layer, and a third buried layer in which the second impurity is higher in concentration than the first.

Thus the invention proposes to create three buried layers in register with one another by taking advantage of the difference in diffusivity between the two *n* type impurities such as antimony and phosphor. The three buried layers consist of the first in which antimony is higher in concentration than phosphor, and the second and the third which lie over and under the first, respectively, and in which phosphor is higher in concentration than antimony. The three buried layers are greater in total thickness and in mean impurity concentration than the conventional single buried layer, making it possible to lower the on-state resistance of the MOS FET or the like.

The present invention may most advantageously be applied to the fabrication of a composite semiconductor device of the type having a first transistor such as a MOS FET and a second transistor such as a BPT. The MOS FET may then be provided with the three registered buried layers as in the foregoing. The BPT, on the other hand, can be fabricated to include only one buried layer constituted of antimony. Little or no phosphor will find its way from MOS FET section into BPT section during the growth of the epitaxial layer. The BPT is hardly affected by the reduction of the MOS FET resistance.

The above and other objects, features and advantages of this invention and the manner of realizing them will become more apparent, and the invention itself will best be understood, from a study of the following description and appended claims, with reference had to the attached drawings showing some preferred embodiments of the invention.

### BRIEF DESCRIPTION OF THE DRAWINGS

**FIG. 1** is a sectional diagram of a composite semiconductor device, including a MOS FET and a BPT together with improved buried layers according to the present invention;
**FIG. 2** is a top plan showing the arrangement of various semiconductor regions of the MOS FET section of the FIG. 1 device;
**FIG. 3** is a schematic electrical diagram of the circuitry of the **FIG. 1** device;
**FIGS. 4A** through **4G** are a series of sectional diagrams sequentially showing the steps of fabricating the **FIG. 1** device by the method of the present invention; and
**FIG. 5** is a graph explanatory of how the buried layers of the **FIG. 1** device are made by the **FIGS. 4A-4G** method.

### DETAILED DESCRIPTION

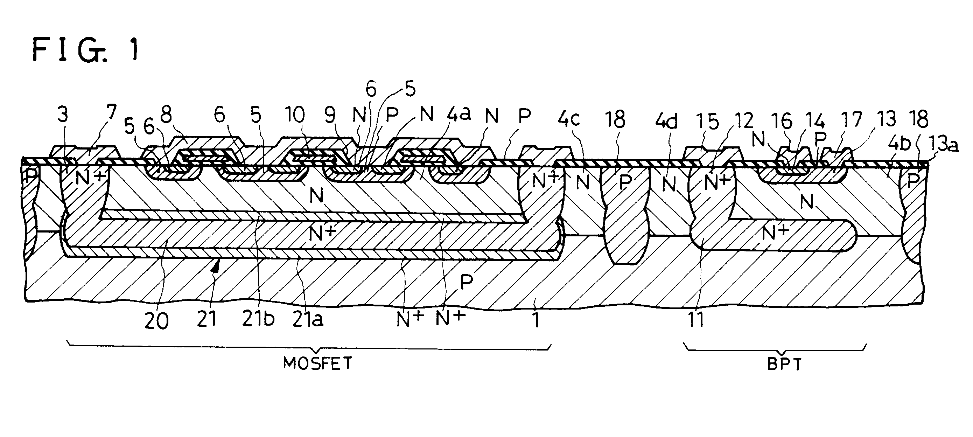

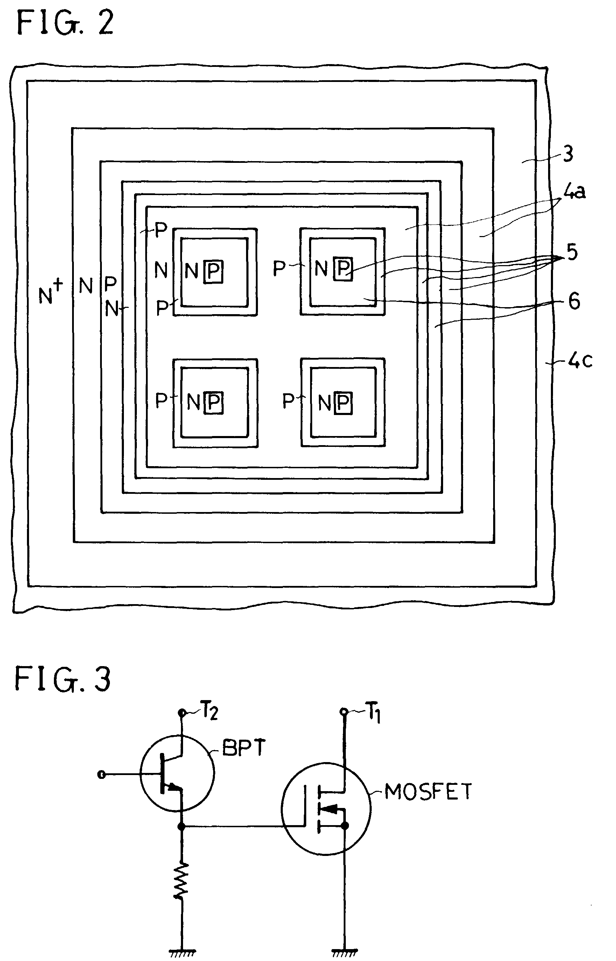

The present invention is believed to manifest its advantages to the full when applied to the composite semiconductor device of improved buried layer configuration shown in **FIGS. 1** and **2**. This semiconductor device is a combination of a MOS FET section and a BPT section formed on one and the same semiconductor substrate. It is understood that the MOS FET of the semiconductor device functions as output transistor, and the BPT as driver.

The MOS FET section of the illustrated device comprises an *n*⁺ type buried layer 20 partly embedded in a *p* type semiconductor substrate 1, two additional *n*⁺ type buried layers 21*a* and 21*b* disposed immediately under and above the first recited buried layer 20, an *n*⁺ type drain contact region 3, an *n* type drain region 4*a*, *p* type base or channel forming regions 5, *n* type source regions 6, a drain electrode 7, a source electrode 8, an insulating film 9, and a gate electrode 10.

The buried layer 20 is shown united with the drain contact region 3 and is further contiguous to the drain region 4*a*; altogether, they form the drain of the MOS FET section. According to the teachings of this invention, all the three buried layers 20, 21*a* and 21*b* of the MOS FET section have both antimony and phosphor diffused therein. However, in the buried layer 20, antimony is higher in concentration than phosphor. The two additional buried layers 21*a* and 21*b* differs from the buried layer 20 in that phosphor concentration is higher than that of antimony. How the three buried layers of such different antimony and phosphor concentrations are created will become apparent from the subsequent discussion of the manufacturing method of this composite semiconductor device.

As will be understood from **FIG. 2**, which is a top plan of the semiconductor part of the MOS FET section of the **FIG. 1** device, the source regions 6 are formed in annular shape within the base regions 5. These base regions 5 are shown as a plurality of, four in the illustrated embodiments, small islands, one ring surrounding each island, and two other rings concentrically surrounding the four islands. The drain contact region 3 surrounds the drain region 4*a*.

With reference back to **FIG. 1** the drain electrode 7 is formed on the drain contact region 3. The source electrode 8 is formed on the base region 5 and source region 6, thereby electrically shorting these regions 5 and 6. Those parts of the base regions 5 which lie between drain region 4*a* and source region 6 function as channels. The gate electrode 10 is formed on these channel portions via an insulating film 9.

Such being the construction of the MOS FET section, *n* type channels will be created in the base region 5 underlying the gate electrode 10 when a positive potential is applied to the gate electrode 10, with the drain electrode 7 made higher in potential than the source electrode 8. Current will then flow from drain electrode 7 to source electrode 8.

The BPT section of the prior art device comprises an *n*⁺ type buried layer 11 partly embedded in the *p* type substrate 1, an *n* type collector region 4*b*, an *n*⁺ type collector contact region 12, a *p* type base region 13, and an *n* type emitter region 14. The buried layer 11 of the BPT section differs from the buried layers 20, 21*a* and 21*b* of the FET section in having only antimony dispersed therein. This buried layer 11 is united with the collector contact region 12 and is contiguous to the collector region 4*b*, so that they form in combination the collector region of the BPT. A collector electrode 15 is formed in low resistance contact with the collector contact region 12. An emitter electrode 16 and a base electrode 17 are formed in low resistance contact with the emitter region 14 and base region 13, respectively.

The MOS FET and BPT sections of the foregoing constructions are electrically separated from each other by a *p* type separator region 18. *N* type regions 4*c* and 4*d* are interposed respectively between the separator region 18 and the drain contact region 3 of the MOS FET section and between the separator region and the collector contact region 12 of the BPT section.

As diagrammatically illustrated in **FIG. 3**, in use of this composite semiconductor device, the MOS FET is to be connected between terminal *T*_{*1*} and ground as output transistor, and the BPT between terminal *T*_{*2*} and the gate electrode of the MOS FET as driver. The illustrated circuitry causes conduction through the MOS FET upon conduction of the BPT, and nonconduction through the MOS FET upon nonconduction of the BPT. Alternatively, the BPT could be connected between the gate of the MOS FET and the ground, thereby causing nonconduction through the MOS FET upon conduction of the BPT.

Conventionally, as has been stated, the composite semiconductor devices comparable to the device set forth above were more or less unsatisfactory in the drain-source on-state resistance of the MOS FET section. Attempts were made, in the manufacture of the prior art devices, which had no additional buried layers 21*a* and 21*b*, to reduce the MOS FET resistance by increasing the impurity concentration, and so decreasing the resistance, of the *n* type drain region 4*a*. However, as the MOS FET drain region 4*a* was made higher in impurity concentration, so was the collector region 4*b* of the BPT, both regions 4*a* and 4*b* being formed concurrently by epitaxial growth. The BPT became then lower in voltage withstanding capability.

The present invention represents a success in the reduction of the MOS FET resistance without in any way adversely affecting the characteristics or performance of the BPT. Prior to the discussion of how this objective is achieved, however, there will be explained the method of fabricating the semiconductor device of the above improved configuration with reference to **FIGS. 4A** through **4G**.

There may first be prepared a *p* type semiconductor substrate 1, as illustrated in **FIG. 4A**. Typically, this substrate is a sheet of silicon, approximately 400 microns thick, doped with boron to a concentration of 1 x 10¹⁵ cm⁻³.

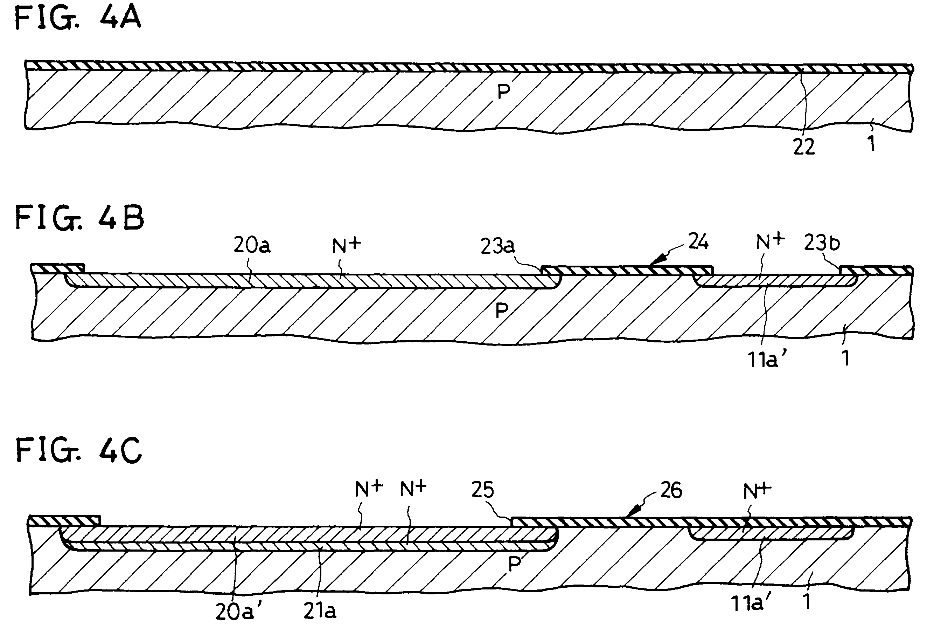

For the creation of buried layers in the substrate 1, a major surface thereof may first be conventionally covered with a silicon oxide film 22, as shown also in **FIG. 4A**. This film is intended for use as a diffusion mask 24, **FIG. 4B**, as windows 23*a* and 23*b* are created therein.

Next comes the step of diffusing antimony, an *n* type impurity, into the substrate 1 through the mask windows 23*a* and 23*b*, thereby forming antimony layers 20*a* and 11*a*', as indicated in **FIG. 4B**. The antimony layer 20*a* is to become part of the first buried layer 20, **FIG. 1,** of the MOS FET, and the other antimony layer 11*a*' part of the buried layer 11 of the BPT. These antimony layers 20*a* and 11*a*' will therefore be hereinafter referred to as the sublayers. Preferably formed with a diffusion temperature of 1200° C, and a diffusion time of 180 minutes, the sub-layers 20*a* and 11*a*' will be 2 x 10¹⁸ cm⁻³ in surface impurity concentration and six microns in depth.

Then the diffusion mask 24 may be replaced by another mask 26, **FIG. 4C**, of silicon oxide which has a window 25 for creation of the second buried layer 21*a* for the MOS FET. The window 25 in the mask 26 is less in size than the window 23*a*, **FIG. 4B**, in the mask 24 but large enough to expose most of the antimony sublayer 20*a*. This difference in size between the mask windows 23*a* and 25 is intended for the creation of the second buried layer 21*a* of approximately the same size as, and in register with, the antimony sublayer 20*a* (i.e., first buried layer 20). The mask 26 thoroughly covers the antimony sublayer 11*a*' for the BPT.

Then phosphor, an *n* type impurity, is introduced through the mask window 25 to form the second buried layer 21*a* under the first formed sublayer which is labeled 20*a*' in **FIG. 4C** because it now contains both antimony and phosphor but which is not yet completed as the first buried layer. The diffusion temperature in this case may be 1150° C., and the diffusion time 150 minutes. The resulting second buried layer 21*a* will be 3 x 10¹⁷ cm⁻³ in surface impurity concentration and eight microns in depth. So much higher in diffusion speed than antimony, phosphor will permeate all through the preformed sublayer 20*a*' and further down into underlying part. There will thus be formed the sublayer 20*a*' of the first buried layer in which antimony is higher in concentration than phosphor, and the second buried layer 21*a* in which phosphor is higher in concentration than antimony. As indicated in **FIG. 4C,** the peripheries of the sublayer 20*a*' and second buried layer 21*a* are substantially in register with each other thanks to the use of the mask windows 23*a* and 25 of different sizes.

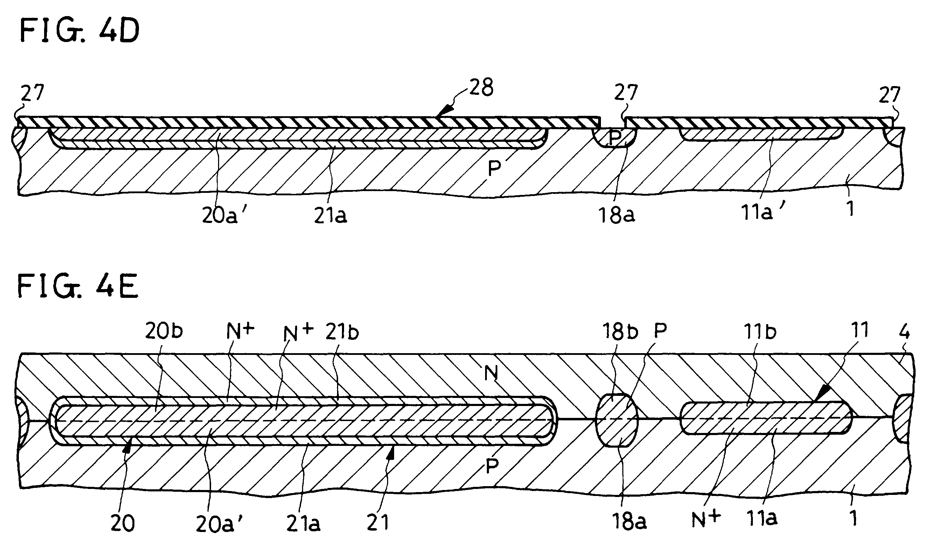

With reference to **FIG. 4D** a third diffusion mask 28, also of silicon oxide, may then be formed on the substrate 1 in place of the mask 26. The mask 28 has formed therein a window 27 for creation of a region 18*a* which is to become part of the separator region 18, **FIG. 1**, between the MOS FET and the BPT sections. The separator region 18 may be reticulate in shape in cases where a number of composite semiconductor devices are being simultaneously manufactured in an array. Boron, a *p* type impurity, is diffused through the mask window 27, preferably at a temperature of 1150° C. and over a period of 150 minutes. The region 18*a* thus formed will be 3 x 10¹⁸ cm⁻³ in impurity concentration and eight microns in depth.

Then the diffusion mask 28 may be removed and, as shown in **FIG. 4E,** an *n* type silicon layer 4 may be grown epitaxially on the major surface of the substrate 1 in gaseous phase. The heat (typically 1180° C.) used during this growth of the epitaxial layer 4 will cause the antimony and phosphor of both predominantly antimony sublayer 20*a*' and predominantly phosphor second buried layer 21*a*, the antimony of the BPT sublayer 11*a*', and the boron of the separator region 18*a*, all of these to thermally diffuse both farther down into the substrate 1 on one hand and, on the other hand, up into the epitaxial layer 4.

The results are depicted somewhat idealized in **FIG. 4E**. The first buried layer 20 of the MOS FET will have been created which comprises the predominantly antimony sublayer 20*a*' within the substrate 1, and the antimony and phosphor sublayer 20*b* which has just been formed within the epitaxial layer 4 by thermal diffusion. Further, over this buried layer 20, a third buried layer 21*b* will have been made within the epitaxial layer 4, in addition to the preformed second buried layer 21*a* under the sublayer 20*a*' or now the first buried layer 20.

Thermally diffused as above from the preformed BPT antimony sublayer 11*a*' the antimony will have formed another similar sublayer 11*b* within the epitaxial layer 4. These sublayers 11*a* and 11*b* constitute in combination the buried layer 11 for the BPT. The separator region 18*a* will have also expanded into the epitaxial layer 4 and created a region 18*b* by thermal diffusion of boron.

Then, as illustrated in **FIG. 4F**, a diffusion mask 30 may be formed once again on the epitaxial layer 4. A *p* type impurity (typically boron) may be diffused into the *n* type epitaxial layer 4 through a window 29 in the mask 30, thereby forming a *p* type semiconductor region 18*c* joined directly to the region 18*b*. The regions 18*a*, 18*b* and 18*c* are all united to form in combination the *p* type separator region 18 electrically separating the MOS FET and BPT sections from each other.

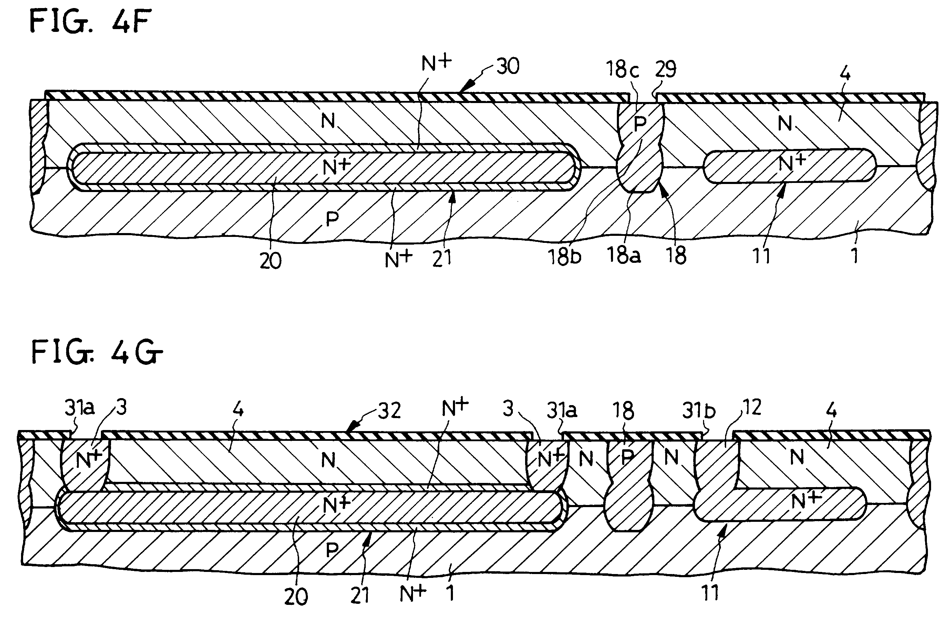

Then the mask 30 may be replaced by a mask 32, **FIG. 4G**, which has windows 31*a* and 31*b* formed therein. An *n* type impurity, typically phosphor, may then be diffused through the mask windows 31*a* and 31*b* thereby forming the drain contact region 3, joined to the MOS FET first buried layer 20, and the collector contact region 12 joined to the BPT buried layer 11.

Then the base regions 5 and source regions 6, both shown in **FIGS. 1** and **2**, of the MOS FET, and the base region 13 and emitter region 14, **FIG. 1,** of the BPT may be formed in the epitaxial layer 4 as by the known double diffusion method. The semiconductor device of **FIG. 1** will be completed as the electrodes 7, 8 and 10 of the MOS FET and the electrodes 15, 16 and 17 of the BPT are formed by vacuum evaporation or like conventional methods.

Actually, in the fabrication of the composite semiconductor device by the method set forth above, the union of the separator subregions 18*b* and 18*c*, union of the drain contact region 3 and MOS FET first buried layer 20, and union of the collector contact region 12 and BPT buried layer 11, are all finally accomplished during the progress of diffusions for creation of the MOS FET base regions 5 and source regions 7 and of the BPT base region 13 and emitter region 14. However, in the foregoing description of the manufacturing method, such unions are assumed to have been achieved earlier, at the steps of **FIGS. 4F** and **4G**, for the ease of explanation and illustration. Also, the buried layers of both MOS FET and BPT undergo some slight changes in shape and size from the **FIG. 4F** step to that of **FIG. 4G**, but such changes are not shown because they are considered unessential for the full understanding of the present invention.

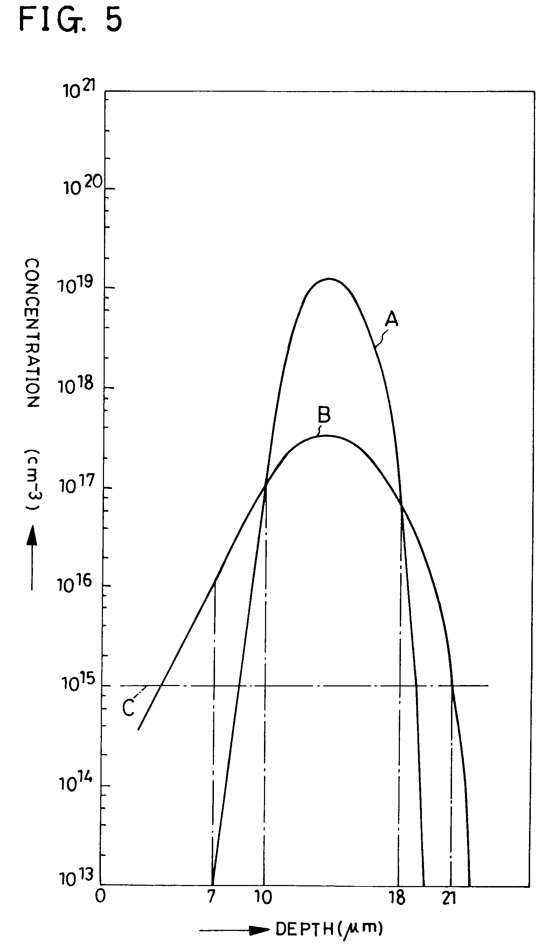

Reference is now directed to **FIG. 5** for a study of the principles upon which the instant invention is based in manufacturing the improved composite semiconductor device of **FIG. 1**. The curves *A* and *B* in the **FIG. 5** graph represent the concentrations of antimony and phosphor, respectively, against the depth of the semiconductor device as measured from the major surface of the epitaxial layer 4. The broken line *C* indicates the impurity concentration of the substrate 1 and the dopant concentration of the epitaxial layer 4.

It will be observed from the graph that the MOS FET first buried layer 20 of the **FIG. 1** device occupies the range of depths from 10 to 18 microns, where antimony is higher in concentration than phosphor. The MOS FET second buried layer 21*a* occupies the range of depths from 18 to 21 microns, immediately under the first buried layer 20, where phosphor is higher in concentration than antimony and where phosphor is higher in concentration than the impurity, boron, of the substrate 1. The MOS FET third buried layer 21*b* occupies the range of depths from seven to ten microns, immediately above the first buried layer 20, where phosphor is higher in concentration than antimony and where the total concentration of phosphor and antimony is not less than about 10¹⁶ cm⁻³, that is, about ten or more times as much as the surface impurity concentration of the epitaxial layer 4.

Actually, no clearcut boundary can possibly be delineated between the drain region 4*a*, **FIG. 1**, and the MOS FET third buried layer 21*b.* For the sake of convenience, however, that boundary is set as above at the depth where the total concentration of phosphor and antimony is approximately ten times as much as the surface impurity concentration of the epitaxial layer 4. Since the surface impurity concentration of the epitaxial layer is now understood to be 1 x 10¹⁵ cm⁻³, the boundary between the drain region 4*a* and the MOS FET third buried layer 21*b* is at the depth of seven microns from the surface of the epitaxial layer 4 in this particular embodiment of the invention.

The boundary between the substrate 1 and the MOS FET second buried layer 21*a*, on the other hand, is hereby defined as the depth where the impurity concentrations of these regions are equal, which depth is 21 microns in this particular embodiment. The MOS FET first buried layer 20 is in the depth range of 10 to 18 microns as aforesaid, so that the two additional buried layers 21*a* and 21*b* are each approximately three microns thick.

Alternatively, the two additional buried layers 21*a* and 21*b* may be redefined as regions where phosphor is higher in concentration than antimony and, at the same time, than the inherent impurities of the substrate 1 and epitaxial layer 4. It is to be understood that the curves *A* and *B* of the **FIG. 5** graph represent the antimony and phosphor distributions after the creation of the epitaxial layer 4 or upon completion of the diffusion processes following the creation of the epitaxial layer.

A study of **FIG. 5** will also reveal that, being so much more diffusive than antimony, phosphor finds its way farther than the MOS FET third buried layer 21*b* and into the drain region 4*a* during the creation of the epitaxial layer 4 as in **FIG. 4E**. The drain region 4*a* is thus made substantially higher in total impurity concentration than heretofore and, in consequence, lower in resistance.

Also, the total thickness of the three buried layers 20, 21*a* and 21*b* of the MOS FET is significantly more than the thickness of the conventional single buried layer. The first buried layer 20 in particular is constituted of both antimony and phosphor, but with antimony made greater in concentration than phosphor by taking advantage of its lower coefficient of diffusion. Thus the total resistance of the three buried layers 20, 21*a* and 21*b* can be made lower than the conventional single buried layer without giving any adverse effect to the BPT.

The buried layer 11 of the BPT, on the other hand, is formed by diffusion of antimony alone according to the invention. Therefore, during the **FIG. 4E** growth of the epitaxial layer 4, no phosphor intrusion will take place into that part of the epitaxial layer which overlies the buried layer 11 and which is to become the collector region 4*b*, **FIG. 1**, of the BPT. The BPT collector region can be made with an impurity concentration determined by the conditions of the epitaxial growth. In short, used in combination with antimony, phosphor serves only to reduce the on-state resistance of the MOS FET and keeps the desired characteristics of the BPT intact.

To make a MOS FET buried layer solely by a high concentration of phosphor would per se be very effective to lower the resistance of the buried layer, as well as of the overlying part of the epitaxial layer. But then, during the subsequent growth of the epitaxial layer, the phosphor would readily evaporate and diffuse into the BPT section of the epitaxial layer, to such an extent as to seriously affect the BPT characteristics.

Too high a phosphor concentration in a MOS FET buried layer would bring about another inconvenience: The phosphor would diffuse into the drain region 4*a* so readily that its impurity concentration would increase inordinately. The MOS FET would then suffer in voltage withstanding capability between its drain and source.

The present invention teaches the provision of both predominantly antimony first buried layer 20 and predominantly phosphor second and third buried layers 21*a* and 21*b*. The phosphor concentrations in these buried layers need not be so high as to significantly affect the total impurity concentration of the epitaxial layer 4. No such inconveniences as those pointed out above will therefore occur thanks to the instant invention.

Those versed in the art might conceive an alternative method in which a MOS FET buried layer is formed solely by antimony diffusion and at a step separate from the creation of a BPT buried layer. However, since antimony is far less diffusive than phosphor, the MOS FET buried layer would not be made thick enough to lower the resistance of the drain region. No substantial reduction would be possible in the on-state resistance of the MOS FET.

It is also to be appreciated that, despite the higher diffusivity of phosphor, the pair of predominantly phosphor second and third buried layers 21*a* and 21*b* do not inconveniently extend beyond the peripheral edges of the predominantly antimony first buried layer 20. This confinement of the predominantly phosphor buried layers 21*a* and 21*b* within the boundaries of the predominantly antimony buried layer 20 is due to the use of the diffusion mask 26, **FIG. 4C**, in creating the buried layer 21*a*. The mask 26 has the window 25 which is less in size than the window 23*a*, **FIG. 4B**, of the diffusion mask 24 used in creating the sublayer 20*a* of the predominantly antimony buried layer.

Despite the foregoing detailed disclosure, it is not desired that the present invention be limited by the exact showings of the drawings or by the description thereof. The following is a brief list of possible modifications or alterations of the illustrated device or of the description thereof;
1. The invention could be applied to various other types of semiconductor devices such as those having additional MOS FETs and/or BPTs as well as such passive elements as resistors and capacitors.
2. A BPT could be used as output transistor in the **FIG. 1** device.
3. A MOS FET could be used as a driver in the **FIG. 1** device.

All such modifications and alterations are intended in the foregoing disclosure. It is therefore appropriate that the present invention be construed broadly and in a manner consistent with the fair meaning or proper scope of the following claims.

## Claims

1. A method of fabricating a semiconductor device of the type having an *n* type semiconductor buried layer, characterized by comprising the steps of: (a) providing a *p* type semiconductor substrate (1); (b) introducing a first *n* type impurity into selected part (20*a*) of the substrate through a major surface thereof; (c) introducing a second *n* type impurity, which is higher in diffusivity than the first impurity, into approximately the same selected part (20*a*) of the substrate through the major surface thereof, thereby forming, thanks to a difference in diffusivity between the first and the second impurities, part (20*a*') of what is to become a first buried layer in which the first impurity is higher in concentration than the second impurity, and a second buried layer (21*a*) in which the second impurity is higher in concentration than the first impurity; and (d) growing an *n* type semiconductor epitaxial layer (4) on the major surface of the substrate, thereby forming, thanks to the thermal diffusion of the first and the second impurities from the substrate into the epitaxial layer at different rates, the first buried layer (20) which comprises the part (20*a*') preformed in the substrate and part (20*b*) newly formed in the epitaxial layer, and a third buried layer (21*b*) in which the second impurity is higher in concentration than the first impurity.

2. The method as claimed In claim 1, characterized in that the first impurity is antimony and the second impurity is phosphor.

3. The method as claimed in claim 1, characterized in that the second impurity is introduced into the substrate through a mask window (25) which is less in size than a mask window (23*a*) through which the first impurity is introduced into the substrate.

4. A method of fabricating a composite semiconductor device of the type having a first and a second transistor each having an *n* type semiconductor buried layer, characterized by comprising the steps of: (a) providing a *p* type semiconductor substrate (1); (b) introducing a first *n* type impurity into first and second selected parts (20*a* and 11*a*') of the substrate through a major surface thereof; (c)introducing a second *n* type impurity, which is higher in diffusivity than the first impurity, approximately into the first selected part (20*a*) of the substrate through the major surface thereof, thereby forming, thanks to the difference in diffusivity between the first and the second impurities, part (20*a*') of what is to become a first buried layer for the first transistor, in which the first impurity is higher in concentration than the second impurity, and a second buried layer (21*a*) for the first transistor in which the second impurity is higher in concentration than the first impurity; and (d) growing an *n* type semiconductor epitaxial layer (4) on the major surface of the substrate, thereby forming, thanks to the thermal diffusion of the first and the second impurities from the substrate into the epitaxial layer at different rates, the first buried layer (20) for the first transistor which comprises the part (20*a*') preformed in the substrate and part (20*b*) newly formed in the epitaxial layer, a third buried layer (21*b*) for the first transistor in which the second impurity is higher in concentration than the first impurity, and a fourth buried layer (11) for the second transistor which is constituted of the first impurity diffused both in the second selected part (11) of the substrate and in part (11*b*) of the epitaxial layer; whereby the first, the second and the third buried layers (20, 21*a* and 21*b*) function in combination to lower the on-state resistance of the first transistor without giving an adverse effect to the second transistor.

5. The method as claimed in claim 4, characterized in that the first impurity is antimony and the second impurity is phosphor.

6. The method as claimed in claim 4, characterized in that the second impurity is introduced into the substrate through a mask window (25) which is less in size than a mask window (23*a*) through which the first impurity is introduced into the substrate.

7. A semiconductor device, characterized by comprising a *b* type semiconductor substrate (1), an *n* type semiconductor epitaxial layer (4) grown on a major surface of the substrate , a first buried layer (20) formed partly in the substrate and partly in the epitaxial layer and containing both a first *n* type impurity and a second *n* type impurity which is higher in diffusivity than the first impurity, with the first impurity being higher in concentration than the second impurity, a second buried layer (21*a*) formed in the substrate and disposed in register with, and contiguous to, the first buried layer, the second buried layer containing the first and the second impurities, with the first impurity being less in concentration than the second impurity, and a third buried layer (21*b*) formed in the epitaxial layer and disposed in register with, and contiguous to, the first buried layer, the third buried layer containing the first and the second impurities, with the first impurity being less in concentration than the second impurity.

8. The semiconductor device as claimed in claim 7, characterized in that the first impurity is antimony and the second impurity is phosphor.

9. The semiconductor device as claimed in claim 7, characterized in that the first, the second and the third buried layers (20, 21*a* and 21*b*) are of approximately the same size in planes parallel to the major surface of the substrate (1).

10. A composite semiconductor device having a first and a second transistor, characterized by comprising a *p* type semiconductor substrate (1), an *n* type semiconductor epitaxial layer (4) grown on a major surface of the substrate, a first buried layer (20) for the first transistor formed partly in the substrate and partly in the epitaxial layer and containing both a first *n* type impurity and a second *n* type impurity which is higher in diffusivity than the first impurity, with the first impurity being higher in concentration than the second impurity, a second buried layer (21*a*) for the first transistor formed in the substrate and disposed in register with, and contiguous to, the first buried layer, the second buried layer containing the first and the second impurities, with the first impurity being less in concentration than the second Impurity, a third buried layer (21*b*) for the first transistor formed in the epitaxial layer and disposed in register with, and contiguous to, the first buried layer, the third buried layer containing the first and the second impurities, with the first impurity being less in concentration than the second impurity, a fourth buried layer (11) for the second transistor constituted of the first impurity diffused partly in the substrate and partly in the epitaxial layer, whereby the on-state resistance of the first transistor can be lowered by the first, the second and the third buried layers (20, 21*a* and 21*b*) without giving an adverse effect to the second transistor.

11. The composite semiconductor device as claimed in claim 10, characterized in that the first impurity is antimony and the second impurity is phosphor.

12. The composite semiconductor device as claimed in claim 10, characterized in that the first, the second and the third buried layers (20, 21*a* and 21*b*) for the first transistor are approximately of the same size in planes parallel to the major surface of the substrate (1).
